# EUROPEAN PATENT APPLICATION

(11) **EP 1 671 997 A1**
(43) Date of publication of application: **21.06.2006**
(21) Application number: 04792163.0
(22) Date of filing: 07.10.2004
(51) Int. Cl.: C08G 59/40

(54) **LATENT CURING AGENT AND COMPOSITION**

(30) Priority: 10.10.2003 JP 2003352693
(71) Applicant: Asahi Kasei Chemicals Corporation, Tokyo 100-8440 (JP)
(72) Inventor: USUI, Taketoshi, Yokohama-shi, Kanagawa 236-0057 (JP); TAKADA, Yoshihiko, Yokohama-shi, Kanagawa 223-0055 (JP)
(74) Representative: HOFFMANN EITLE
(86) International application number: PCT/JP2004/014866
(87) International publication number: WO 2005/035617

(57) **Abstract**

A latent curing agent for an epoxy resin containing a curing agent (A) for an epoxy resin and a resin coating said curing agent (A) for an epoxy resin, wherein the resin coating said curing agent (A) for an epoxy resin comprises a structure in which two of the structure (structure (1)) are bonded via a urea bonding, the structure (1) being obtained by bonding three sulfur atoms at a branching point via a linear or cyclic aliphatic hydrocarbon group optionally containing an ester structure, wherein at least one of nitrogen atoms of each structure (1) is incorporated into said urea bonding; and a one component epoxy resin composition using the latent curing agent. The above one component epoxy resin composition which can exhibit high curability and storage stability in combination. The above latent curing agent can suitably used for producing the one component epoxy resin composition, which can provide an anisotropic electroconductive material, an electroconductive adhesive material, an insulating adhesive material, a sealing material or the like which exhibits high storage stability, and also exhibits high adhesion reliability and adhesive strength and high sealability.

## Description

### TECHNICAL FIELD

The present invention relates to a novel latent curing agent for an epoxy resin and a one-component epoxy resin composition using the same. More particularly, the present invention relates to a latent curing agent for an epoxy resin composition having not only high curability but also excellent storage stability and a one-component epoxy resin composition using the same.

### BACKGROUND ART

Epoxy resins have been used in a wide variety of applications such as paints, electric/electronic insulating materials, and adhesive agents since their cured products have excellent performance in properties such as mechanical characteristics, electric characteristics, thermal characteristics, chemical resistance, and adhesion. General epoxy resin compositions presently in use belong to a so-called two-component composition, which is used by mixing two liquids, an epoxy resin and a curing agent, when used.
The two-component epoxy resin composition can be cured at room temperature. On the other hand, the epoxy resin and the curing agent must be separately stored. When used, they are measured, if necessary, mixed and put in use. Therefore, the storage and handling of the epoxy resin composition are complicated.
In addition, since application-available time is limited, a large amount of mixture cannot be prepared in advance. Therefore, the mixing operation must be performed frequently, inevitably decreasing operating efficiency.
To overcome these problems intrinsic to such a two-component epoxy resin composition, several one-component epoxy resin composition have been proposed including a one-component epoxy resin composition containing an epoxy resin and a latent curing agent, such as a dicyandiamide, BF₃-amine complex, amine salt, or modified imidazole compound.

Of the latent curing agents, however, when agents are excellent in storage stability but poor in curability, they require high temperature and long time for curing. On the other hand, when agents are excellent in curability but poor in storage stability, they must be stored at a temperature as low as -20°C. To describe more specifically, the storage stability of a composition containing dicyandiamide is not less than 6 months when stored at room temperature; however, it requires a curing temperature of not less than 170°C. If a curing accelerator is used to reduce the curing temperature, curing can be performed at 130°C; however, the storage stability at room temperature becomes insufficient, with the result that it is inevitably stored at low temperature. In the circumstances, a composition capable of satisfying not only high curability but also excellent storage stability has been strongly desired. Furthermore, when a film-form product and a product having a base impregnated with an epoxy resin are obtained, in most cases, a solvent and a reactive diluent must be contained in the compositions. When a conventional latent curing agent is employed as a curing agent in such a composition, the storage stability extremely decreases. For this reason, virtually, the composition must be prepared in a two-component form. Hence, improvement has been required.

To satisfy the requirement, many studies have been made. For example, a curing agent for an epoxy resin having a surface coated with a reaction product of an isocyanate compound is described in JP-A-61-190521 (Patent Document 1), JP-A-1-70523 (Patent Document 2), and JP-A-11-193344 (Patent Document 3).
However, recently, particularly in the electron machinery field, it is required to attain high integration of a circuit and improve contact reliability, to use a material having a low heat resistance in order to reduce the weight of mobile machines and to drastically improve productivity. To satisfy these requirements, a one-component epoxy resin composition, which is used as a connecting material, is strongly desired to improve curability without losing storage stability. Unfortunately, it has been difficult to satisfy the desire by a conventional technology.
Patent Document 1: JP-A-61-190521
Patent Document 2: JP-A-1-70523
Patent Document 3: JP-A-11-193344

### DISCLOSURE OF INVENTION

### PROBLEM TO BE SOLVED BY THE INVENTION

It is an object of the present invention to provide a one-component epoxy resin composition capable of satisfying not only high curability but also storage stability and a latent curing agent for realizing these characteristics, and further to provide an anisotropic conductive material, conductive adhesive material, insulating adhesive material, and sealing material which can impart high adhesion reliability, adhesive strength and high sealing property even if curing is performed at low temperature or in a short time.

### MEANS FOR SOLVING THE PROBLEM

The present inventors have conducted studies with a view to solving the aforementioned problems. As a result, they found that a latent curing agent for an epoxy resin whose surface is coated with a film having a specific structure fits the aforementioned object and attained the present invention.
More specifically, the present invention is as follows:
I) A latent curing agent for an epoxy resin comprising a curing agent (A) for an epoxy resin and a resin coating the curing agent (A) for an epoxy resin, characterized in that
   the resin coating the curing agent (A) for an epoxy resin comprises a structure in which two structures (structures (1)) are mutually bonded via one urea bond, the structures (1) each obtained by bonding three nitrogen atoms at a branching point via a linear or cyclic aliphatic hydrocarbon group which may optionally contain an ester structure; and at least one of the nitrogen atoms of each of the structures (1) is incorporated in the urea bond.
II) The latent curing agent for an epoxy resin according to item I), characterized in that
   the resin coating the curing agent (A) for an epoxy resin further comprises an aromatic hydrocarbon group (2) bonded to not less than two nitrogen atoms; and
   the ratio of the aromatic hydrocarbon group (2) bonded to not less than two nitrogen atoms to the total amount of the structures (1) and the aromatic hydrocarbon group (2) bonded to not less than two nitrogen atoms is between 0.5% by mass and 95% by mass.
III) The latent curing agent for an epoxy resin according to item II), characterized in that
   the ratio of the aromatic hydrocarbon group (2) bonded to not less than two nitrogen atoms to the total amount of the structures (1) and the aromatic hydrocarbon group (2) bonded to not less than two nitrogen atoms is between 1% by mass and 80% by mass.
IV) A latent curing agent for an epoxy resin comprising
   a curing agent (A) for an epoxy resin; and
   a resin coating the latent curing agent (A) for an epoxy resin and obtained by the reaction between an isocyanate component (b1), which has not less than three isocyanate groups and contains low molecular weight polyisocyanate having no molecular weight distribution in an amount of not less than 20% by mass, and an active hydrogen compound (b2).
V) The latent curing agent for an epoxy resin according to item IV), characterized in that the resin coating the latent curing agent (A) for an epoxy resin has a bonding group (x) absorbing infrared ray having a wavelength of 1630 cm⁻¹ to 1680 cm⁻¹.
VI) The latent curing agent for an epoxy resin according to item IV) or V), characterized in that the isocyanate component (b1) contains 20% by mass to 99% by mass of the low molecular weight polyisocyanate compound and 1% by mass to 80% by mass of other isocyanate compounds.
VII) The latent curing agent for an epoxy resin according to any one of items I) to VI), characterized in that the curing agent (A) for an epoxy resin is an amine curing agent.
VIII) The latent curing agent for an epoxy resin according to any one of items I) to VII), characterized in that the resin coating the curing agent (A) for an epoxy resin has a glass transition temperature (Tg) of 80°C or less.
IX) A core-shell type curing agent for an epoxy resin comprising the latent curing agent for an epoxy resin according to any one of items I) to VIII) as a core and a reaction product between the curing agent (A) for an epoxy resin and an epoxy resin (C) as a shell.
X) A master batch type curing agent for an epoxy resin comprising 100 parts by mass of the latent curing agent for an epoxy resin according to any one of items I) to VIII) or the core-shell type curing agent according to item VI) and 10 to 50,000 parts by mass of the epoxy resin (C).
XI) A one-component epoxy resin composition comprising, as main components
   100 parts by mass of an epoxy resin (D); and
   0.1 to 1,000 parts by mass of the latent curing agent for an epoxy resin according to any one of items I) to VIII), the core-shell type curing agent for an epoxy resin according to item IX), or the master batch type curing agent for an epoxy resin according to claim X).
XII) A one-component epoxy resin composition comprising, as main components
   100 parts by mass of an epoxy resin (D);
   1 to 200 parts by mass of at least one curing agent (E) selected from the group consisting of acid anhydrides, phenols, hydrazides, and guanidines; and
   0.1 to 200 parts by mass of the latent curing agent for an epoxy resin according to any one of items I) to VIII), the core-shell type curing agent for an epoxy resin according to item IX), or the master batch type curing agent for an epoxy resin according to item X) .
XIII) An anisotropic conductive material comprising the one-component epoxy resin composition according to item XI) or XII).
XIV) A conductive adhesive material comprising the one-component epoxy resin composition according to item XI) or XII).
XV) An insulating adhesive material comprising the one-component epoxy resin composition according to item XI) or XII).
XVI) A sealing material comprising the one-component epoxy resin composition according to item XI) or XII).
XVII) A method of manufacturing a latent curing agent for an epoxy resin comprising coating a curing agent (A) for an epoxy resin with a film that is formed by reacting an isocyanate component (b1), which has not less than three isocyanate groups and contains low molecular weight polyisocyanate compound having no molecular weight distribution in an amount of 20% by mass or more, with an active hydrogen compound (b2).

### ADVANTAGES OF THE INVENTION

The curing agent of the present invention is effective in attaining not only high curability but also storage stability.

### BEST MODE FOR CARRYING OUT THE INVENTION

A latent curing agent for an epoxy resin according to the present invention is characterized by being coated with a resin having a structure constituted of structures (1), which are directly bonded while sharing two nitrogen atoms with the same urea structure (bond). The structure (1) contains three nitrogen atoms, at least one of which is incorporated in the urea bond. The three nitrogen atoms are bonded at a branching point with a straight or cyclic aliphatic hydrocarbon group (which may optionally contain an ester structure) interposed between the branching point and each of the three nitrogen atoms. In the straight or cyclic aliphatic hydrocarbon group, which may optionally contain an ester structure, interposed between the nitrogen atom incorporated in the urea bond and the branching point, the number of carbon atoms contained in the molecular chain from the urea bond to the branching point is preferably 1 to 20 (including the carbon atom at the branching point). If the number of carbon atoms is larger than 20, storage stability may not be sufficiently exhibited. From such a point of view, it is desirable that the number of carbon atoms is preferably 1 to 10, and more preferably, 1 to 7.
The total number of carbon atoms contained in the molecular chain from the branching point to another nitrogen atom, which is different from the nitrogen atom contained in the urea bond, is preferably 1 to 20 (including the atom at the branching point). If the number of carbon atoms is larger than 20, storage stability is not sufficiently exhibited. From such a point of view, it is desirable that the number of carbon atoms is preferably 1 to 10, and more preferably, 1 to 7.
Furthermore, the total of the number of carbon atoms from the urea bond to the atom of the branching point and the number of carbon atoms from the urea bond to the nitrogen atom, which is different from the urea bond mentioned above, is preferably 3 to 20. If the total number of carbon atoms is smaller than 3, the reactivity of a latent curing agent for an epoxy resin may decrease; on the other hand, if the total number is larger than 20, the storage stability may not be sufficiently exhibited. From such a point of view, it is desirable that the total number of carbon atoms is preferably 4 to 20, and more preferably, 5 to 10.

In other words, the characteristic structure (1) of the present invention is expressed as follows if focus is put on a single urea bond. That is, each of the two nitrogen atoms constituting the urea bond is part of three nitrogen atoms, which are bonded at a branching point with a straight or cyclic aliphatic hydrocarbon group, which may optionally contains an ester structure, interposed between each of them.
Furthermore, the present invention comprises a structure (1) in which three nitrogen atoms are bonded at a branching point with a straight or cyclic aliphatic hydrocarbon group interposed between each of them, which may optionally contain an ester structure. The number of ester bonds contained in a molecular chain involving three nitrogen atoms is desirably 0 to 5. If the number is 5 or more, the storage stability may not be sufficiently exhibited. From such a point of view, the number of ester bonds is preferably 0 to 2 and particularly preferably 0.

A latent curing agent for an epoxy resin according to the present invention is characterized by being coated with a resin having a structure constituted of structures (1), which are directly bonded while sharing two nitrogen atoms with the same urea structure (bond). The structure (1) contains three nitrogen atoms, at least one of which is incorporated in the urea bond. The three nitrogen atoms are bonded at a branching point with a straight or cyclic aliphatic hydrocarbon group (which may optionally contain an ester structure) interposed between the branching point and each of the three nitrogen atoms. Of the three nitrogen atoms, the nitrogen atoms excluding one constituting the urea bond preferably form any one of the bonds selected from a urethane bond and a buret bond in view of exhibiting not only curability but also storage stability.
When the nitrogen atoms of the three nitrogen atoms contained in the structure (1) and excluding one forming the urea bond form any one of the bonds selected from a urethane bond and a buret bond, the nitrogen atoms generally bond to the structures (1), (2), or a structure derived from the active hydrogen compound (b2) (described later) via such a bond.

Examples of the structure (1) include
a structure where an element, which is positioned next to the urea bond with 5 methylene chains interposed between them, is bonded to another nitrogen atom (different from the nitrogen atom mentioned above) with a single tertiary carbon serving as the branching point and 5 methylene chains (which are sequentially arranged in this order) interposed between them, and still another nitrogen atom is directly bonded to the tertiary carbon serving as the branching point;
a structure where an element, which is positioned next to the urea bond with 4 methylene chains interposed between them, is bonded to another nitrogen atom (different from the nitrogen atom mentioned above) with a single tertiary carbon serving as a blanching point and 3 methylene chains (which area sequentially arranged in this order) interposed between them, and still another nitrogen atom is bonded to the tertiary carbon serving as the branching point with a single methylene group interposed between them;
a structure where an element, which is positioned next to the urea bond with 3 methylene chains interposed between them, is bonded to another nitrogen atom (different from the nitrogen atom mentioned above) with a single tertiary carbon serving as a branching point and 2 methylene chains (which are sequentially arranged in this order) interposed between them, and still another nitrogen atom is directly bonded to the tertiary carbon serving as the branching point;
a structure where an element, which is positioned next to the urea bond with 4 methylene chains interposed between them, is bonded to another nitrogen atom (different from the nitrogen atom mentioned above) with a single tertiary carbon serving as a branching point, a COO bond, and a single propylene group (which are sequentially arranged in this order) interposed between them, and still another nitrogen atom is directly bonded to the tertiary carbon serving as the branching point;

a structure where an element, which is positioned next to the urea bond with a cyclohexyl ring interposed between them, is bonded to another nitrogen atom (different from the nitrogen atom mentioned above) with a single tertiary carbon serving as a branching point and the cyclohexyl ring (which are sequentially arranged in this order) interposed between them, and still another nitrogen atom is bonded to the tertiary carbon serving as the branching point with the cyclohexyl ring interposed between them;
a structure where another nitrogen atom (different from the two nitrogen atoms mentioned above) is bonded to the urea bond with a bicycloheptane ring interposed between them; and
a structure where an element, which is positioned next to the urea bond with 4 methylene chains interposed between them, is bonded to another nitrogen bond (different from the nitrogen atom mentioned above) with a single tertiary carbon serving as a branching point, a COO bond, and 2 methylene chains (which are sequentially arranged in this order) interposed between them; and still another nitrogen atom is directly bonded to the tertiary carbon serving as the branching point.
Of these structures, in terms of a balance between the storage stability and curability of a one-component epoxy resin composition, the following two structures are preferable.
One is the structure where an element, which is positioned next to the urea bond with 4 methylene chains interposed between them, is bonded to another nitrogen atom (different from the nitrogen atom mentioned above) with a single tertiary carbon serving as a blanching point and 3 methylene chains (which area sequentially arranged in this order) interposed between them, and still another nitrogen atom is bonded to the tertiary carbon serving as the branching point with a single methylene group interposed between them; and
the other is the structure where an element, which is positioned next to the urea bond with 4 methylene chains interposed between them, is bonded to another nitrogen bond (different from the nitrogen atom mentioned above) with a single tertiary carbon serving as a branching point, a COO bond, and 2 methylene groups (which are sequentially arranged in this order) interposed between them; and still another nitrogen atom is directly bonded to the tertiary carbon serving as the branching point.

A latent curing agent for an epoxy resin according to the present invention is characterized by containing a structure (1) where three nitrogen atoms, at least one of which is incorporated in a urea bond, are bonded at a branching point with a straight or cyclic aliphatic hydrocarbon group (which may optionally contain an ester structure) interposed between the branching point and the each of the nitrogen atoms. The latent curing agent may further contain an aromatic hydrocarbon group (2) bonded to not less than two nitrogen atoms.
Examples of a structure where the aromatic hydrocarbon group (2) is bonded to not less than two nitrogen atoms include,
a structure where two nitrogen atoms at the ortho position, a nitrogen atom each at the ortho position and the metha position, two nitrogen atoms at the metha position, a nitrogen atom each at the ortho position and the para position, or a nitrogen atom each at the metha position and the para position with respect to a methyl group bonded to a benzene ring;
a structure where two nitrogen atoms are bonded to a benzene ring and one of the two nitrogen atoms is bonded to the ortho position, metha position, or para position with respect to the other nitrogen atom; and
a structure where two benzene rings mutually bonded with a methylene chain interposed between them and a nitrogen atom bonds to the ortho, metha, or para position of each of the benzene rings with respect to the methylene chain.
When the ratio of the aromatic hydrocarbon group (2) to the total amount of the structure (1) and the aromatic hydrocarbon group (2) bonded to not less than two nitrogen atoms is not more than 0.5% by mass, the storage stability of a master batch obtained when an epoxy resin is mixed may decrease. When the ratio is greater than 95% by mass, the effect of the present invention may not be obtained. From this point of view, the ratio of the aromatic hydrocarbon group (2) to the total amount of the structure (1) and the structure (2) is preferably from 0.5% by mass to 95% by mass, more preferably, 1% by mass to 80% by mass, and further preferably, 5% by mass to 70% by mass.

The main component of a resin coating the latent curing agent for an epoxy resin is desirably a urethane resin.
Such a urethane resin can be synthesized by the reaction between an isocyanate compound and a compound having not less than one hydroxyl group per molecule.
Examples of such an isocyanate compound include aliphatic diisocyanates, alicyclic diisocyanates, aromatic diisocyanates, aliphatic triisocyanates, and polyisocyanates. Examples of the aliphatic diisocyanates include ethylene diisocyanate, propylene diisocyanate, butylene diisocyanate, hexamethylene diisocyanate, and trimethylhexamethylene diisocyanate. Examples of the alicyclic diisocyanates include isophorone diisocyanate, 4-4'-dicyclohexylmethane diisocyanate, norbornane diisocyanate, 1,4-isocyanatocyclohexane, 1,3-bis(isocyanatomethyl)-cyclohexane, and 1,3-bis(2-isocyanatopropyl-2yl)cyclohexane. Examples of the aromatic diisocyanates include trilene diisocyanate, 4,4'-diphenylmethane diisocyanate, xylene diisocyanate, and 1,5-naphthalene diisocyanate. Examples of the aliphatic triisocyanates include 1,3,6-triisocyanate methylhexane, and 2,6-diisocyanatohexanoic acid-2-isocyanatoethyl. Examples of the polycyanates include polymethylene polyphenyl polycyanate and a polycyanate derived from the diisocyanate compounds mentioned above. Examples of the polycyanate derived from the diisocyanate compounds mentioned above include an isocyanulate-type polyisocyanate, buret type polyisocyanate, urethane-type polyisocyanate, allophanate-type polyisocyanate, and carbodiimide-type polyisocyanate.

Examples of the compound having not less than one hydroxyl group per molecule include alcohol compounds and phenol compounds. Examples of the alcohol compounds include mono alcohols such as methyl alcohol, propyl alcohol, butyl alcohol, amyl alcohol, hexyl alcohol, heptyl alcohol, octyl alcohol, nonyl alcohol, decyl alcohol, undecyl alcohol, lauryl alcohol, dodecyl alcohol, stearyl alcohol, eicosyl alcohol, allyl alcohol, crotyl alcohol, propargyl alcohol, cyclopentanol, cyclohexanol, benzyl alcohol, cinnamyl alcohol, ethylene glycol monomethyl ether, ethylene glycol monomethyl ether, ethylene glycol monoethyl ether, and diethylene glycol monobutyl; and polyhydric alcohols such as ethylene glycol, polyethylene glycol, propylene glycol, polypropylene glycol, 1,3-butanediol, 1,4-butanediol, hydrogenated bisphenol A, neopentyl glycol, glycerin, trimethylolpropane, and pentaerythritol. Furthermore, compounds having not less than two secondary hydroxyl groups per molecule, which is obtained by the reaction between a compound having not less than one epoxy groups per molecule and a compound having not less than one hydroxyl group, carboxyl group, primary or secondary amino group, or mercapto group may be included in the examples of the poly alcohols. As the alcohol compound, any one of primary, secondary or tertiary alcohols may be used. Examples of the phenol compound include mono phenols such as phenol, cresol, xylenol, carvacrol, motyl, and naphthol; and polyvalence phenols such as catechol, resorcin, hydroquinone, bisphenol A, bisphenol F, pyrogallol, and phloroglucin.

A latent curing agent for an epoxy resin according to the present invention can be synthesized by, for example, coating a curing agent (A) for an epoxy resin with a film obtained by the reaction between isocyanate component (b1) and an active hydrogen compound (b2).

Examples of the curing agent (A) for an epoxy resin include acid anhydride curing agents such as amine curing agent, phthalic anhydride, hexahydrophthalic anhydride, tetrahydrophthalic anhydride, and methylnadic acid; phenol curing agents such as phenol novolak, cresol novolak, and bisphenol A novolak; mercaptan curing agents such as propylene glycol modified polymercaptan, thioglycolic acid ester of trimethylolpropane, and polysulfide resin; halogeneated boron salts such as an ethylamine salt of trifluoroborane; quarternary ammonium salt curing agents such as a phenol salt of 1,8-diazabicyclo(5,4,0)-undecene-7; urea curing agents such as 3-phenyl-1,1-dimethylurea; and phosphine curing agents such as triphenylphosphine, and tetraphenylphosphonium tetraphenylborate. Of them, amine curing agents are preferable since they are excellent in low-temperature curability and storage stability.

Examples of the amine curing agents include compounds having primary, secondary, or tertiary amino group. They can be used in combination.
Examples of the compound having a primary amino group include primary amines such as ethylenediamine, diethylenetriamine, triethylenetetramine, tetraethylenepentamine, hexamethylenediamine, isophorone diamine, bis(4-amino-3-methylcyclohexyl)methane, diamino dicyclohexyl methane, methaxylenediamine, diaminodiphenylmethane, diaminodiphenylsulfone, and metha phenylenediamine; guanidines such as dicyan diamide, methylguanidine, ethylguanidine, propylguanidine, butylguanidine, dimethylguanidine, trimethylguanidine, phenylguanidine, diphenylguanidine, and tolylguanidine; and acid hydrazides such as dihydrazide succinate, dihydrazide adipate, dihydrazide phthalate, dihydrazide isophthalate, dihydrazide terephthalate, dihydrazide p-oxybenzoate, hydrazide salicylate, hydrazide phenylaminopropionate, and dihydrazide maleate.
Examples of the compound containing a secondary amino group include piperidine, pyrrolidine, diphenylamine, 2-methylimidazole, and 2-ethyl-4-methylimidazole.

Examples of the compound containing a tertiary amino group include
(1) imidazoles such as 1-cyanoethyl-2-undecyl-imidazole-trimellitate, imidazolyl succinic acid, 2-methylimidazole succinic acid, 2-ethylimidazole succinic acid, 1-cyanoethyl-2-methyl imidazole, 1-cyanoethyl-2-undecyl imidazole, and 1-cyanoethyl-2-phenyl imidazole; and lower molecular tertiary amines such as benzyldimethylamine, triethanolamine, 2,4,6-tris(dimethylaminomethyl)phenol, N,N'-dimethyl piperazine, triethylenediamine, 1,8-diazabicyclo(5,4,0)-undecene-7,1,5-diazabicyclo(4,3,0)-nonene-5, pyridine, and picoline,
(2) a reaction product (A-1) between a compound having at least one primary amino group and no tertiary amino group and/or a compound having at least one secondary amino group and no tertiary amino group, and an epoxy compound,
(3) a reaction product (A-2) between a compound having both at least one active hydrogen group and a tertiary amino group, and at least one compound selected from the group consisting of a carboxylic acid compound, sulfonic acid compound, isocyanate compound and urea compound and epoxy compound.

Next, a starting material for the reaction product (A-1) will be described.
As the compound having at least one primary amino group and no tertiary amino group, use may be made of any one of aliphatic primary amine, alicyclic primary amine, and aromatic primary amine. Examples of the aliphatic primary amine include methylamine, ethylamine, propylamine, butylamine, ethylenediamine, propylenediamine, hexamethylenediamine, diethylenetriamine, triethylenetetramine, ethanolamine, and propanolamine. Examples of the aliphatic primary amine include cyclohexylamine and isohoronediamine. Examples of the aromatic primary amine include aniline, toluidine, diaminodiphenylmethane, and diaminodiphenyl sulfone. Examples of the compound having at least one secondary amino group and no tertiary amino group, use may be made of any one of aliphatic secondary amine, alicyclic secondary amine, and aromatic secondary amine. Examples of the aliphatic secondary amine include dimethylamine, diethylamine, dipropylamine, dibutylamine, dipentylamine, dihexylamine, dimethanolamine, diethanolamine and dipropanolamine. Examples of the alicyclic secondary amine include dicyclohexylamine, piperidine, and piperidone. Examples of the aromatic secondary amine include diphenylamine, phenylmethylamine, and phenylethylamine.

As an epoxy compound serving as a starting material for the reaction product (A-1), either a monoepoxy compound or a polyvalence epoxy compound, or a mixture thereof may be used. Examples of the monoepoxy compound include butyl glycidyl ether, hexyl glycidyl ether, phenyl glycidyl ether, allyl glycidyl ether, p-tert-butylphenyl glycidyl ether, ethylene oxide, propylene oxide, paraxylyl glycidyl ether, glycidyl acetate, glycidyl butyrate, glycidyl hexoate, and glycidyl benzoate.

Examples of the polyvalent epoxy compound include bisphenol type epoxy resins obtained by glycidylating bisphenols such as bisphenol A, bisphenol F, bisphenol AD, bisphenol S, tetramethyl bisphenol A, tetramethyl bisphenol F, tetramethyl bisphenol AD, tetramethyl bisphenol S, tetrabromo bisphenol A, tetrachloro bisphenol A, and tetrafluoro bisphenol A; epoxy resins obtained by glycidylating divalent phenols such as bisphenol, dihydroxynaphthalene, and 9,9-bis(4-hydroxyphenyl)fluorene; epoxy resins obtained by glycidylating trisphenols such as 1,1,1-tris(4-hydroxyphenyl)methane, and 4,4-(1-(4-(1-(4-hydroxyphenyl)-1-methylethyl)phenyl)ethylidene)bisphenol; epoxy resins obtained by glycidylating tetrakis phenols such as 1,1,2,2-tetrakis(4-hydroxyphenyl)ethane; novolak type epoxy resins obtained by glycidylating novolaks such as phenol novolak, cresol novolak, bisphenol A novolak, brominated phenol novolak, and brominated bisphenol A novolak; aliphatic ether type epoxy resins obtained by glycidylating poly alcohols such as glycerin and polyethylene glycol; ether ester type epoxy resins obtained by glycidylating hydroxycarboxylic acids such as p-oxybenzoate and β-oxynaphthoate; ester type epoxy resins obtained by glycidylating polycarboxylic acids such as phthalic acid and terephthalic acid; compounds obtained by glycidylating amine compounds such as 4,4-diaminodiphenyl methane and m-amino phenol; amine type epoxy resins such as triglycidyl isocyanulate; and alicyclic epoxides such as 3,4-epoxycyclohexylmethyl-3',4'-epoxycyclohexane carboxylate.

As the epoxy compound serving as a starting material for a reaction product (A-1), a polyvalent compound is preferably used since resultant cured product is excellent in adhesion and heat resistance, more preferably, an epoxy resin obtained by glycidylating a polyvalent phenol, and further preferably, a bisphenol type epoxy resin is used. To easily obtain the reaction product (A-1), a glycidylated bisphenol A and glycidylated bisphenol F are further preferable. Glycidylated bisphenol A is further more preferable.
The molecule of an epoxy compound generally has an impure terminal having chlorine bonded thereto. The total amount of chlorine in an epoxy compound serving as a starting material for a reaction product (A-1) is preferably less than 2,000 ppm, since the cured product is excellent in electric characteristics, more preferably, less than 1,500 ppm, further preferably, less than 1,000 ppm, and further more preferably, less than 500 ppm.

Next, a starting material for a reaction product (A-2) will be explained.
In the compound having at least one active hydrogen group simultaneously with a tertiary amino group and used as a starting material for the reaction product (A-2), as the active hydrogen group, mention may be made of a primary amino group, secondary amino group, hydroxyl group, thiol group, carboxylic acid, and hydrazide group. Examples of the compound having at least one active hydrogen group simultaneously with a tertiary amino group include aminoalcohols such as 2-dimethylaminoethanol, 1-methyl-2-dimethylaminoethanol, 1-phenoxymethyl-2-dimethylaminoethanol, 2-diethylaminoethanol, 1-butoxymethyl-2-dimethylaminoethanol, methyldimethanolamine, triethanolamine, and N-β-hydroxyethylmorpholine, aminophenols such as 2-(dimethylaminomethyl)phenol, 2,4,6-tris(dimethylaminomethyl)phenol; imidazoles such as 2-methylimidazole, 2-ethyl-4-methylimidazole, 2-undecylimidazole, 2-heptadecylimidazole, 2-phenylimidazole, 1-aminoethyl-2-methylimidazole, 1-(2-hydroxy-3-phenoxypropyl)-2-methylimidazole, 1-(2-hydroxy-3-phenoxypropyl)-2-ethyl-4-methylimidazole, 1-(2-hydroxy-3-butoxypropyl)-2-methylimidazole, and 1-(2-hydroxy-3-butoxypropyl)-2-ethyl-4-methylimidazole; imidazolines such as 1-(2-hydroxy-3-phenoxypropyl)-2-phenylimidazoline, 1-(2-hydroxy-3-butoxypropyl)-2-methylimidazoline, 2-methylimidazoline, 2,4-dimethylimidazoline, 2-ethylimidazoline, 2-ethyl-4-methylimidazoline, 2-benzylimidazoline, 2-phenylimidazoline, 2-(o-tolyl)-imidazoline, tetramethylene-bis-imidazoline, 1,1,3-trimethyl-1,4-tetramethylene-bis-imidazoline, 1,3,3-trimethyl-1,4-tetramethylene-bis-imidazoline, 1,1,3-trimethyl-1,4-tetramethylene-bis-4-methylimidazoline, 1,3,3-trimethyl-1,4-tetramethylene-bis-4-methylimidazoline, 1,2-phenylene-bis-imidazoline, 1,3-phenylene-bis-imidazoline, 1,4-phenylene-bis-imidazoline, and 1,4-phenylene-bis-4-methylimidazoline; tertiary aminoamines such as dimethylaminopropylamine, diethylaminopropylamine, dipropylaminopropylamine, dibutylaminopropylamine, dimethylaminoethylamine, iethyl aminoethylamine, dipropylaminoethylamine, dibutylaminoethylamine, N-methylpiperazine, N-aminoethylpiperazine, and diethylaminoethylpiperazine; aminomercaptans such as 2-dimethylaminoethanethiol, 2-mercaptobenzoimidazole, 2-mercaptobenzothiazole, 2-mercaptopyridine, and 4-mercaptopyridine; aminocarboxylic acids such as N,N-dimethylaminobenzoate, N, N-dimethyl glycine, nicotinic acid, isonicotinic acid, and picolinic acid; and amino hydrazides such as N,N-dimethylglycine hydrazide, nicotinic acid hydrazide, and isonicotinic acid hydrazide.
Furthermore, a reaction product (A-1) can be used as a starting material for a reaction product (A-2) as a compound having a hydroxyl group and a tertiary amino group.

As the compound having at least one active hydrogen group simultaneously with a tertiary amino group per molecule, a reaction product (A-1) and an imidazole are preferably used since they are excellent in storage stability and curability, more preferably an imidazole, and further preferably, 2-methylimidazole and 2-ethyl-4-methylimidazole is used.
Examples of the carboxylic acid compound, sulfonic acid compound, isocyanate compound, urea compound and epoxy compound to be used as a starting material for a reaction product (A-2) will be described below.
Examples of the carboxylic acid compound include succinic acid, adipic acid, sebacic acid, phthalic acid, and dimer acid.
Examples of the sulfonic acid include ethane sulfonic acid and p-toluenesulfonic acid.
Examples of the isocyanate compound include aliphatic diisocyanate, alicyclic diisocyanate, aromatic diisocyanate, aliphatic triisocyanate, and polyisocyanate. Examples of the aliphatic diisocyanate include ethylene diisocyanate, propylene diisocyanate, butylene diisocyanate, hexamethylene diisocyanate, and trimethylhexamethylene diisocyanate. Examples of the alicyclic diisocyanate include isophorone diisocyanate, 4-4'-dicyclohexylmethane diisocyanate, norbornane diisocyanate, 1,4-isocyanatocyclohexane, 1,3-bis(isocyanatomethyl)-cyclohexane, and 1,3-bis(2-isocyanatopropyl-2yl)-cyclohexane. Examples of the aromatic diisocyanate include tolylene diisocyanate, 4,4'-diphenylmethan diisocyanate, xylene diisocyanate, and 1,5-naphthalene diisocyanate. Examples of the aliphatic triisocyanate include 1,3,6-triisocyanate methylhexane, and 2,6-diisocyanato hexanoic acid-2-isocyanatoethyl. Examples of the polyisocyanate include polymethylenepolyphenyl polyisocyanate and a polyisocyanate derived from the aforementioned diisocyanate compounds. As the polyisocyanate derived from the aforementioned diisocyanate compounds, mention may be made of isocyanulate-type polyisocyanate, buret type polyisocyanate, urethane type polyisocyanate, allophanate type polyisocyanate, and carbodiimide type polyisocyanate.

Examples of the urea compound include urea, methylurea, dimethylurea, ethylurea, and t-butylurea.
Examples of the epoxy compound include epoxy compounds exemplified as a starting material for a reaction compound (A-1).
Of the group consisting of a carboxylic acid compound, sulfonic acid compound, isocyanate compound, urea compound and epoxy compound serving as a stating material for a reaction product (A-2), the epoxy compound is preferable since the resultant cured product is excellent in performance such as adhesion and heat resistance. More preferably, use may be made of a polyvalence epoxy compound and further preferably, an epoxy resin obtained by glycidylating a polyvalence phenol. To easily obtain a reaction product (A-1), a compound obtained by glycidylating bis phenol A and a compound obtained by glycidylating bisphenol F are further more preferable and a compound obtained by glycidylating bisphenol A is particularly preferable.

The molecule of an epoxy compound generally has an impure terminal having chlorine bonded thereto. The total amount of chlorine in an epoxy compound serving as a starting material for a reaction product (A-2) is preferably less than 2,000 ppm, since the cured product is excellent in electric characteristics, more preferably, less than 1,500 ppm, further preferably, less than 1,000 ppm, and further more preferably, less than 500 ppm.
To obtain a reaction product (A-2), a compound having not less than two active hydrogen groups per molecule can be used simultaneously as a third component. Examples of the compound having not less than two active hydrogen groups per molecule include, but not particularly limited to, amines such as ethylenediamine, propylenediamine, hexamethylenediamine, diethylenetriamine, triethylenetetramine, ethanolamine, dimethanolamine, diethanolamine, dipropanolamine, methaxylenediamine, 1,3-bis(aminomethyl)cyclohexane, isohorondiamine, diaminocyclohexane, phenylenediamine, tolylenediamine, diaminodiphenylmethane, diaminodiphenyl sulfone, and piperazine; polyvalent phenols such as bisphenol A, bisphenol F, bisphenol S, hydroquinone, catechol, resorcinol, pyrogallol, and phenol novolak resin; poly alcohols such as trimethylol propane; polyvalent carboxylic acids such as adipic acid and phthalic acid; 1,2-dimercaptoethane, 2-mercaptoethanol, 1-mercapto-3-phenoxy-2-propanol, mercaptoacetic acid, anthranilic acid, and lactic acid. These may be used in combination.

Furthermore, a reaction product (A-2) may employ a compound having a primary or secondary amino group per molecule as a starting material. Examples of such a compound include a compound having a primary amino group in a molecule of methylamine, ethylamine, propylamine, butylamine, cyclohexylamine, aniline, and toluidine, etc.; and a compound having as secondary amino group in a molecule of dimethylamine, diethylamine, dipropylamine, dibutylamine, dipentylamine, dihexylamine, dicyclohexylamine, diphenylamine, phenylmethylamine, and phenylethylamine, etc. They may be used in combination.

A reaction product (A-1) and a reaction product (A-2) can be obtained by mixing starting materials all at a time or in several times, subjecting the resultant mixture to a reaction performed, if necessary, in the presence of a solvent, generally at a temperature range of 40°C to 250°C for 0.1 to 24 hours, and removing an unreacted starting material and the solvent as needed.
When a reaction product (A-1) is obtained, the ratio of starting materials is preferably set as follows. The ratio in equivalent of the total of the primary amino group and secondary amino group contained in a compound having at least one primary amino group per molecule and no tertiary amino group and/or a compound having at least one secondary amino group and no tertiary amino group to the epoxy group in an epoxy compound preferably falls in the range of 1/5 to 5/1. When a reaction product (A-2) is obtained, the ratio in equivalent of the active hydrogen group contained in a compound having at least one active hydrogen group simultaneously with a tertiary amino group to the total of a carboxylic group, sulfonic group, isocyanate group, urea group and epoxy group contained in a carboxylic acid compound, sulfonic acid compound, isocyanate compound, urea compound and/or epoxy compound preferably falls within the range of 1/5 to 5/1.

Examples of the solvent to be used as needed include, but not particularly limited to, hydrocarbons such as benzene, toluene, xylene, cyclohexane, mineral sprit, and naphtha; ketones such as acetone, methyl ethyl ketone, and methyl isobutyl ketone; esters such as ethyl acetate, n-butyl acetate, and propylene glycol monomethyl ethyl ether acetate; alcohols such as methanol, isopropanol, n-butanol, butyl cellosolve, and butyl carbitol; and water. These solvent may be used in combination.

As the amine curing agent (A) for an epoxy resin for use in the present invention, an amine compound having a tertiary amino group is preferably used since it is excellent in curability and storage stability. More preferably, a reaction product (A-1) and a reaction product (A-2), further preferably, a reaction product (A-2), and further more preferably, a reaction product (A-2) containing a tertiary amino group and not containing a primary and/or a secondary amino group is used.
As the form of the curing agent (A) for an epoxy resin, mention may be made of liquid, massive, granular, and powdery forms, etc. Granular or powdery form is preferably and powdery form is more preferably used. The powdery form used herein is not particularly limited; however, powder having an average particle size of 0.1 to 50 µm is preferable, and powder having an average particle size of 0.5 to 10 µm is more preferable. A homogenous cured material can be obtained by using powder having an average particle size of 50 µm or less. The particle diameter used herein refers to a stoke diameter measured by the light-scattering photometry. The average particle size used herein refers to as a median diameter. The shape of the particles is not particularly limited, and either spherical or indefinite form may be used. To reduce the viscosity of a master batch or a one-component epoxy resin composition, a spherical shape is preferable. The term "spherical" used herein includes not only a perfect spherical and indefinite shape with rounded corners.

Next, the isocyanate component (b1) will be explained.
The isocyanate component (b1) to be used in the invention contains a low-molecular weight polyisocyanate compound in an amount of 20% by mass or more.
The low-molecular weight polyisocyanate compound has not less than three isocyanate groups and no molecular weight distribution. Examples of the low-molecular weight polyisocyanate compound include aliphatic low-molecular weight polyisocyanate compounds such as 1,6,11-undecane triisocyanate, 1, 8-diisocyanate-4-isocyanate methyloctane, 1,3,6-hexamethylene triisocyanate, 2,6-diisocyanatohexanoic acid-2-isocyanatoethyl, and 2,6-diisocyanatohexanoic acid-1-methyl-2-isocyanatoethyl; and alicyclic low molecular weight polyisocyanate compounds such as tricyclohexylmethane triisocyanate, and bicycloheptane triisocyanate. As the low molecular weight polyisocyanate compound, mention may be preferably made of aliphatic low-molecular weight polyisocyanate compound in view of a good balance between storage stability and curability of the one-component epoxy resin composition obtained, more preferably, 1,8-diisocyanate-4-isocyanate methyloctane and 2,6-diisocyanatehexanoic acid-2-isocyanatoethyl in view of an industrial availability; and further preferably 2,6-diisocyanatohexanoic acid-2-isocyanatoethyl.
The phrase "has no molecular weight distribution" means that the peak of a main component occupies 70% or more in the GPC measured by the method mentioned in Examples.
Furthermore, the term, "low molecular weight" means a molecule having a number average molecular weight of 2,000 or less obtained by the GPC measured by the method described in Examples.

As an isocyanate component (b1), not only a low molecular weight polyisocyanate compound but also another isocyanate compound may be used simultaneously. Examples of the other isocyanate compound include aliphatic diisocyanate, alicyclic diisocyanate, aromatic diisocyanate, and polyisocyanate. Examples of the aliphatic diisocyanate include ethylene isocyanate, propylene diisocyanate, butylenes diisocyanate, hexamethylene diisocyanate, and trimethylhexanemethylene diisocyanate. Examples of the alicyclic diisocyanate include isophorone diisocyanate, 4-4'-dicyclohexylmethane diisocyanate, norbornene diisocyanate, 1,4-isocyanatocyclohexane, 1,3-bis(isocyanatomethyl)-cyclohexane, and 1,3-bis(2-isocyanatopropyl-2yl)-cyclohexane. Examples of the aromatic diisocyanate include tolylene diisocyanate, 4,4'-diphenylmethane diisocyanate, xylene diisocyanate, and 1,5-naphthalene diisocyanate. Examples of the polyisocyanate include polymeric isocyanates such as polymethylene polyphenyl polyisocyanate, and polyisocyanates derived from the diisocyanates mentioned above and low molecular weight polyisocyanate compounds mentioned above. Examples of the polyisocyanate derived from the diisocyanates mentioned above and low molecular weight polyisocyanate compounds include an isocyanulate type polyisocyanate, buret type polyisocyanate, and urethane type polyisocyanate, allophanate-type polyisocyanate, and carbodiimide type polyisocyanate.

Use of the other isocyanate compound is effective to improve the dispersibility of a latent curing agent according to the present invention in mixing it with a one-component epoxy resin composition or in producing a master batch type curing agent, thereby suppressing secondary coagulation of the latent curing agent. In this respect, as the other isocyanate compound, aromatic diisocyanate, alicyclic diisocyanate, and polymeric isocyanate are preferably used, and polymethylenepolyphenyl polyisocyanate is more preferably used.
The ratio of a low molecular weight polyisocyanate compound occupied in the isocyanate component (b1) is required to be not less than 20% by mass to improve not only storage stability but also curability, preferably not less than 20% by mass to less than 99% by mass, further preferably not less than 30% by mass to less than 95% by mass, and further more preferably, not less than 40% by mass to less than 90% by mass.

As the active hydrogen compound (b2) to be used in the present invention, mention may be made of water, a compound having not less than one primary and/or secondary amino group per molecule, and a compound having not less than one hydroxyl group per molecule. Of them, water and the compound having not less than one hydroxyl group per molecule are preferable. These may be used in combination.
As the compound having not less than one primary and/or secondary amino group per molecule to be used as the active hydrogen compound (b2), use may be made of an aliphatic amine, alicyclic amine, and aromatic amine. Examples of the aliphatic amine include alkyl amines such as methylamine, ethylamine, propylamine, butylamine, and dibutylamine; alkylenediamines such as ethylenediamine, propylenediamine, butylenediamine, and hexamethylenediamine; polyalkylenepolyamines such as diethylenetriamine, triethylenetetramine, and tetraethylenepentamine; and polyoxyalkylene polyamines such as polyoxypropylenediamine, and polyoxyethylenediamine. Examples of the alicyclic amine include cyclopropylamine, cyclobutylamine, cyclopentylamine, cyclohexyl amine, and isophoronediamine. Examples of the aromatic amine include aniline, toluidine, benzylamine, naphthylamine, diaminodiphenyl methane, and diamino diphenylsulfone.

As the compound having not less than one hydroxyl group per molecule and used as an active hydrogen compound (b2), mention may be made of an alcohol compound and a phenol compound. Examples of the alcohol compounds include mono alcohols such as methyl alcohol, propyl alcohol, butyl alcohol, amyl alcohol, hexyl alcohol, heptyl alcohol, octyl alcohol, nonyl alcohol, decyl alcohol, undecyl alcohol, lauryl alcohol, dodecyl alcohol, stearyl alcohol, eicosyl alcohol, allyl alcohol, crotyl alcohol, propargyl alcohol, cyclopentanol, cyclohexanol, benzyl alcohol, cinnamyl alcohol, ethylene glycol monomethyl ether, ethylene glycol monoethyl ether, and diethylene glycol monobutyl; and polyalcohols such as ethylene glycol, polyethylene glycol, propylene glycol, polypropylene glycol, 1,3-butanediol, 1,4-butanediol, hydrogenated bisphenol A, neopentylglycol, glycerin, trimethylolpropane, and pentaerythritol. Also, a compound having not less than two secondary hydroxyl groups per molecule, which is obtained by the reaction between a compound having not less than one epoxy group per molecule and a compound having not less than one hydroxyl group, carboxyl group, a primary or secondary amino group, or mercapto group per molecule is included as an example of the polyalcohol. In these alcohol compounds, any one of primary, secondary or tertiary alcohols may be used. Examples of the phenol compound include monophenols such as phenol, cresol, xylenol, carvacrol, motyl, and naphthol; and polyphenols such as catechol, resorcin, hydroquinone, bisphenol A, bisphenol F, pyrogallol, and phloroglucine. As the compound having not less than one hydroxyl group per molecule, use is preferably made of a polyalcohol and a polyphenol. Of them, a polyalcohol is further preferable.

The reaction between an isocyanate component (b1) and an active hydrogen compound (b2) is generally performed in a temperature range from -10°C to 150°C for a reaction time of 10 minutes to 12 hours. If the reaction temperature is lower than -10°C, the reaction proceeds at a low speed and therefore not preferable from economic point of view. If the reaction temperature is 150°C or more, the reaction proceeds too fast and therefore not preferable from a safety point of view. From this point, a preferable reaction temperature is 30°C to 120°C, and more preferably, 50°C to 100°C. If necessary, the reaction may be performed in a dispersion medium. Examples of the dispersion medium include a solvent, plasticizer, and resin. Examples of the solvent include carbohydrates such as benzene, toluene, xylene, cyclohexane, mineral spirit, and naphtha; ketones such as acetone, methyl ethyl ketone, and methyl isobutyl ketone; esters such as ethyl acetate, n-butyl acetate, and propylene glycol monomethyl ethyl ether acetate; alcohols such as methanol, isopropanol, n-butanol, butyl cellosolve, and butyl carbitol; and water. Examples of the plasticizer include diesters of phthalic acid such as dibutyl phthalate, di(2-ethylhexyl)phthalate; aliphatic dibasic acid ester such as di(2-ethylhexyl)adipate; phosphate triesters such as tricresyl phosphate; and glycol esters such as polyethylene glycol ester. Examples of the resin include silicone resins, epoxy resins and phenol resins.
The ratio in amount of the isocyanate component (b1) to the active hydrogen compound (b2) is not particularly limited; they are usually used in such a manner that the ratio of the isocyanate group of the isocyanate component (b1) to the active hydrogen of the active hydrogen compound (b2) falls within the range of 1:0.1 to 1:1,000 in terms of an equivalent amount.

Examples of a method of coating a curing agent (A) for an epoxy resin with the reaction product between an isocyanate component (b1) and an active hydrogen compound (b2) include a method in which the obtained reaction product is dissolved, the solubility of the reaction product decreases in a liquid having a curing agent (A) for an epoxy resin dispersed therein, thereby precipitating the reaction product on the surface of the curing agent (A) for an epoxy resin; and a method in which an isocyanate component (b1) and an active hydrogen compound (b2) are reacted in the state where a curing agent (A) for an epoxy resin is dispersed in a dispersion medium, thereby precipitating the reaction product on the surface of the curing agent
(A) for an epoxy resin, or they are reacted on the surface (used as a reaction field) of the curing agent

(A) for an epoxy resin, thereby generating the reaction product on the surface thereof. The latter method is preferable since the reaction and coating can be performed simultaneously.
   The obtained coating film may preferably have a bonding group (x) absorbing infrared rays having a wavelength from 1630 cm⁻¹ to 1680 cm⁻¹. As the bonding group (x), a urea bond is particularly preferable. Furthermore, the obtained coating film may preferable have a bonding group (y) absorbing infrared rays of a wavelength from 1680 cm⁻¹ to 1725 cm⁻¹ and/or a bonding group (z) absorbing infrared rays of a wavelength from 1730 cm⁻¹ to 1755 cm⁻¹. It is particularly preferable that a buret bond is used as the bonding group (y) and an urethane bond as the bonding group (z).
   The urea bond and buret bond are produced by the reaction between an isocyanate compound and water and/or an amine compound having not less than one primary and/or secondary amino group per molecule. The urethane bond is produced by the reaction between an isocyanate compound and a compound having not less than one hydroxyl group per molecule.

The Tg of the obtained coating film is preferably -20°C to 100°C. If the Tg is -20°C or less, the stability may not be exhibited sufficiently; on the other hand, if the Tg is 80°C or more, the curability may decrease. From such a point of view, it is desirable that the Tg is preferably 0°C to 80°C, more preferably 10°C to 60°C, and particularly preferably, 20°C to 50°C.

It is preferable that the latent curing agent of the present invention is formed into a core-shell type curing agent (as explained below), since further higher storage stability can be obtained.
The core-shell type curing agent for an epoxy resin of the present invention is formed of a latent curing agent for an epoxy resin according to the present invention as the core and a reaction product between a curing agent (A) for an epoxy resin and an epoxy resin (C) as the shell.
Examples of the epoxy resin (C) used in the present invention include bisphenol type epoxy resins obtained by glycidylating bisphenols such as bisphenol A, bisphenol F, bisphenol AD, bisphenol S, tetramethyl bisphenol A, tetramethyl bisphenol F, tetramethyl bisphenol AD, tetramethyl bisphenol S, tetrabromo bisphenol A, tetrachloro bisphenol A, and tetrafluoro bisphenol A; epoxy resins obtained by glycidylating divalent phenols such as biphenol, dihydroxy naphthalene, 9,9-bis(4-hydroxyphenyl)fluorene; epoxy resins obtained by glycidylating trisphenols such as 1,1,1-tris(4-hydroxyphenyl)methane, and 4,4-(1-(4-(1-(4-hydroxyphenyl)-1-methylethyl)phenyl)ethylidene)bisphenol; epoxy resins obtained by glycidylating tetrakis phenols such as 1,1,2,2-tetrakis(4-hydroxyphenyl)ethane; novolak type epoxy resins obtained by glycidylating novolaks such as phenol novolak, cresol novolak, bisphenol A novolak, brominated phenol novolak, and brominated bisphenol A novolak; aliphatic ether ester type epoxy resins obtained by glycidylating polyalcohol such as glycerin and polyethylene glycol; ether ester type epoxy resins obtained by glycidylating hydroxyl carboxylic acids such as p-oxy benzoate and β-oxy naphthoate; ester type epoxy resins obtained by glycidylating polycarboxylic acids such as phthalic acid and terephthalic acid; compounds obtained by glycidylating amine compounds such as 4,4-diaminodipheyl methane and m-aminophenol; amine type epoxy resins such as triglycidyl isocyanuate; and alicyclic epoxides such as 3,4-epoxycyclohexylmethyl-3',4'-epoxycyclohexane carboxylate. These epoxy resins may be used alone or in combination.

As the epoxy resin (C), an epoxy resin obtained by glycidylating a polyphenol is preferably used since the resultant cured product is excellent in adhesion and heat resistance, and a bisphenol-type epoxy resin is more preferably used. A glycidylated compound of bisphenol A and a glycidylated compound of bisphenol F are further preferable. Of them, a glycidylated compound of bisphenol A is further more preferable.
The molecule of an epoxy compound generally has an impure terminal having chlorine bonded thereto. The total amount of chlorine in an epoxy compound serving as a starting material for a reaction product (A-1) is preferably less than 2,000 ppm, since the cured product excellent in electric characteristics can be obtained, more preferably, less than 1,500 ppm, further preferably, less than 1,000 ppm, and further more preferably, less than 500 ppm.
The reaction between a curing agent (A) for an epoxy resin and an epoxy resin (C) is generally performed within the temperature range of -10°C to 150°C, preferably, 0°C to 100°C for a reaction time of 1 to 168 hours, preferably 2 to 72 hours and may be performed in a dispersant medium. As the dispersant medium, use may be made of a solvent and a plasticizer.

Examples of the solvent include hydrocarbons such as benzene, toluene, xylene, cyclohexane, mineral sprit, and naphtha; ketones such as acetone, methyl ethyl ketone, and methyl isobutyl ketone; esters such as ethyl acetate, n-butyl acetate, and propylene glycol monomethylethylether acetate; alcohols such as methanol, isopropanol, n-butanol, butyl cellosolve, and butyl carbitol; and water. Examples of the plasticizer include diesters of phthalic acid such as dibutyl phthalate, di(2-ethylhexyl) phthalate; aliphatic dibasic acid ester such as di(2-ethylhexyl)adipate; phosphate triesters such as tricresyl phosphate; and glycol esters such as polyethylene glycol ester.
The ratio in amount of a curing agent (A) for an epoxy resin to an epoxy resin (C) is not particularly limited; however, it generally falls within the range of 1:0.001 to 1:1,000, and preferably 1:0.01 to 1:100 in terms of mass ratio.
As a method for coating a core (hereinafter referred to as "the core") formed of a latent curing agent of the present invention with a shell (hereinafter referred to as "the shell") formed of the reaction product between a curing agent (A) for an epoxy resin and an epoxy resin (C), mention is made of a method in which the shell is dissolved and the solubility of the shell is reduced in a dispersion medium having the core dispersed therein, thereby precipitating the shell on the surface of the core; and a method in which the core is dispersed in an epoxy resin (C) and/or a dispersion medium having an epoxy resin (C) dissolved therein, and then the curing agent (A) for an epoxy resin and the epoxy resin (C) are reacted, thereby precipitating the shell on the surface of the core, or they are reacted on the surface of the core (used as a reaction field), thereby generating the shell on the surface thereof. The latter method is preferable since the reaction and coating can be performed simultaneously.
In the latter method, as a curing agent (A) for an epoxy resin, the curing agent (A) for an epoxy resin used in the core may be used or another epoxy-resin curing agent may be separately added.
The thickness of the shell covering the surface of the core is preferably 5 to 1,000 nm in an average film thickness. If the thickness is 5 nm or more, storage stability can be obtained. If the thickness is 1,000 nm or less, curability can be virtually obtained. The thickness of the layer used herein can be observed by a transmission electron microscope. The thickness of the shell is particularly preferably 10 to 100 nm in an average film thickness.

A latent curing agent according to the present invention and/or core-shell type curing agent is preferably used in the form of a master batch type curing agent described below, since it can be easily mixed with an epoxy resin in obtaining a one-component epoxy resin composition.
The master batch type curing agent for en epoxy resin of the present invention contains an epoxy resin (C) in an amount of 10 to 50,000 parts by mass (preferably, 20 to 20,000 parts by mass) based on 100 parts by mass of a latent curing agent according to the present invention and/or core-shell type curing agent. If the epoxy resin (C) is contained in an amount of not less than 10 parts by mass, the master batch type curing agent easily handled can be obtained. If the epoxy resin (C) is contained in an amount of not more than 50,000 parts by mass, the performance as a curing agent is virtually exhibited.

As a method of manufacturing a master batch type curing agent according to the present invention, mention may be made of a method in which a latent curing agent and/or core-shell type curing agent according to the present invention as previously manufactured is dispersed in an epoxy resin (C) by use of three rolls or the like; and a method in which a reaction for generating a latent curing agent and/or core-shell type curing agent is performed in an epoxy resin (C) to obtain the latent curing agent and/or core-shell type curing agent, simultaneously with a master batch type curing agent. The latter method is preferable in terms of productivity.
The master batch type curing agent of the present invention is preferably a liquid or paste at room temperature, more preferably has a viscosity of 500,000 mPa·s or less at 25°C, further preferably, 1000 to 300,000 mPa·s, and further more preferably, 3,000 to 200,000 mPa·s.
The viscosity is preferably 500,000 mPa·s or less, because the workability of the curing agent is high sufficient to reduce the adhesion amount to a container, thereby reducing waste.
The master batch type curing agent of the present invention is constituted of a latent curing agent and/or a core-shell type curing agent according to the present invention and an epoxy resin (C); however other component(s) may be contained within the range in which the function of the curing agent is not decreased. The content of the other component(s) is preferably less than 30% by mass.

The latent curing agent, core-shell type curing agent, and/or a master batch type curing agent of the present invention (hereinafter referred to as "curing agent of the present invention") are added to an epoxy resin (D) to obtain a one-component epoxy resin composition.
The epoxy resin (D) to be used in the one-component epoxy resin composition of the present invention may have not less than two epoxy groups per molecule in average.
Examples of the epoxy resin (D) include bisphenol type epoxy resins obtained by glycidylating bisphenols such as bisphenol A, bisphenol F, bisphenol AD, bisphenol S, tetramethyl bisphenol A, tetramethyl bisphenol F, tetramethyl bisphenol AD, tetramethyl bisphenol S, tetrabromo bisphenol A, tetrachloro bisphenol A, and tetrafluoro bisphenol A; epoxy resins obtained by glycidylating divalent phenols such as biphenol, dihydroxynaphthalene, 9,9-bis(4-hydroxyphenyl)fluorene; epoxy resins obtained by glycidylating trisphenols such as 1,1,1-tris(4-hydroxyphenyl)methane, and 4,4-(1-(4-(1-(4-hydroxyphenyl)-1-methylethyl)phenyl)ethylidene)bisphenol; epoxy resins obtained by glycidylating tetrakis phenols such as 1,1,2,2-tetrakis(4-hydroxyphenyl)ethane; novolak type epoxy resins obtained by glycidylating novolaks such as phenol novolak, cresol novolak, bisphenol A novolak, brominated phenol novolak, and brominated bisphenol A novolak; aliphatic ether type epoxy resins obtained by glycidylating polyalcohols such as glycerin and polyethylene glycol; ether ester type epoxy resins obtained by glycidylating hydroxycarboxylic acids such as p-oxybenzoate and β-oxynaphthoate; ester type epoxy resins obtained by glycidylating polycarboxylic acids such as phthalic acid and terephthalic acid; compounds obtained by glycidylating amine compounds such as 4,4-diaminodiphenylmethane and m-aminophenol; amine type epoxy resins such as triglycidyl isocyanulate; and alicyclic epoxides such as, 3,4-epoxycyclohexylmethyl-3',4'-epoxycyclohexane carboxylate.
Furthermore, examples of the epoxy resin (D) to be used in the present invention may include a polymeric epoxy resin generally called a phenoxy resin having a self-film formation property.

The mixing ratio of a curing agent of the present invention and an epoxy resin (D) is determined in view of curability and characteristics of a cured product. Preferably, the curing agent of the present invention may be used in an amount of 0.1 to 1,000 parts by mass based on 100 parts by mass of an epoxy resin (D), more preferably, 0.2 to 500 parts by mass, and further preferably 0.5 to 200 parts by mass. In the amount of not less than 0.1 part by mass, a satisfactory curability can be virtually obtained. In the amount of not more than 1,000 parts by mass, a curing agent having a good balance in curability without a phenomenon where a latent curing agent and/or core-shell type curing agent are localized.
The one-component epoxy resin composition of the present invention may further include a curing agent (E) other than a master batch type curing agent according to the present invention.
The curing agent (E) may be selected from the group consisting of acid anhydrides, phenols, hydrazides, and guanidines. They may be used in combination.
Examples of the acid anhydrides include phthalic acid anhydride, trimellitic acid anhydride, pyromellitic acid anhydride, hexahydrophthalic acid anhydride, tetrahydrophthalic acid anhydride, 3-chlorophthalic acid anhydride, 4-chlorophthalic acid anhydride, benzophenone tetra carboxylic acid anhydride, succinate acid anhydride, methylsuccinic acid anhydride, dimethylsuccinic acid anhydride, dichlorosuccinic acid anhydride, methylnadic acid, dodecylsuccinic acid, chlorendic acid anhydride, and maleic acid anhydride. Examples of the phenols include phenol novolak, cresol novolak, and bisphenol A novolak. Examples of hydrazines include dihydrazide succinate, dihydrazide adipate, dihydrazide phthalate, dihydrazide isophthalate, dihydrazide terephthalate, dihydrazide p-oxybenzoate, hydrazide salicylate, hydrazide phenylamino propionate, and dihydrazide maleate. Examples of the guanidines include dicyandiamide, methylguanidine, ethylguanidine, propylguanidine, butylguanidine, dimethylguanidine, trimethylguanidine, phenylguanidine, diphenylguanidine, and tolylguanidine.
As the curing agent (E), mention may be preferably made of guanidines and acid anhydrides, and more preferably, dicyandiamide, hexahydrophthalic acid anhydride, methyltetrahydro phthalic acid anhydride, and methylnadic acid anhydride.

When a curing agent (E) is used, the curing agent (E) is used in an amount of 1 to 200 parts by mass and the curing agent of the present invention is used in an amount of 0.1 to 200 parts by mass based on 100 parts by mass of an epoxy resin (D).
Within the aforementioned range of the curing agents used herein, a composition excellent in curability and storage stability can be obtained and a cured product excellent in heat resistance and water resistance can be obtained.
When a one-component epoxy resin composition is manufactured by use of the curing agent of the present invention, if desired, a thickening agent, resinforcing agent, filler, conductive fine particles, pigment, organic solvent, reactive diluent, non-reactive diluent, resin and coupling agent, etc. may be added. Examples of the filler include coal tar, glass fiber, asbestos fiber, boron fiber, carbon fiber, cellulose, polyethylene powder, polypropylene powder, quartz fiber, mineral silicate, mica, asbestos powder, slate powder, kaoline, aluminum oxide trihydrate, aluminium hydroxide, chalk, plaster stone, calcium carbonate, antimony trioxide, penton, silica, aerosol, lithopone, barite, titanium dioxide, carbon black, graphite, iron oxide, gold, aluminum powder, and iron powder. These may be effectively used in accordance with the use. Examples of the organic solvent include, toluene, xylene, methyl ethyl ketone, methyl isobutyl ketone, ethyl acetate and butyl acetate. Examples of the reactive diluent include butyl glycidyl ether, N,N'-glycidyl-o-toluidine, phenyl glycidyl ether, styrene oxide, ethylene glycol diglycidyl ether, propylene glycol diglycidyl ether, and 1,6-hexanediol diglycidyl ether. Examples of the non-reactive diluent include dioctyl phthalate, dibutyl phthalate, dioctyl adipate, and petroleum solvent. Example of the resin include a polyester resin, polyurethane resin, acrylic resin, polyether resin, melamine resin, modified epoxy resins such as urethane modified epoxy resin, rubber modified epoxy resin, and alkyd modified epoxy resin.

In the one-component epoxy resin composition of the present invention, a curing agent of the present invention, an epoxy resin (D) and, if necessary, a curing agent (E) serve as main components. The one-component epoxy resin composition of the present invention is cured with heating to exhibit a desired performance. The main components used herein refer to components mainly participated in a curing reaction with heating and preferably occupy 60% or more of heat curable components (the total amount of components of the composition excluding components which are not participated in curing, in other words, which are non-reactive components having an extremely small effect on acceleration or deceleration of the reaction). Further preferably, the main components occupy 70% or more.
Examples of the components of the one-component epoxy resin composition not participated in curing include a thickening agent, resinforcing agent, filling agent, conductive particles, pigment, organic solvent, and resin. These components may be preferably used within the range of 0 to 90% by mass based on the total amount of a one-component epoxy resin composition.

The one-component epoxy resin composition of the present invention is useful as an adhesive agent, sealing material, filler, insulating material, conductive material, anisotropic conductive material, sealing material, and prepreg, etc. As the adhesive agent, the composition is useful as a liquid adhesive agent, film-type adhesive agent, and die bonding material, etc. As the sealing material, the composition is useful as a solid sealing material, liquid sealing material, and film-form sealing material, etc. As the liquid sealing material, the composition is useful as an underfill, potting material, and dam material. As the insulating material, the composition is useful as an insulative adhesion film, insulating adhesion paste, and solder resist. As the conductive material, the composition is useful as a conductive film and a conductive paste. As the anisotropic conductive material, the composition is useful as anisotropic conductive film and anisotropic conductive paste.
When use is made of a conductive material and anisotropic conductive material, conductive particles are dispersed in a one-component epoxy resin composition according to the present invention. As the conductive particles, use may be made of metal particles such as solder particles, nickel particles, copper-silver gradient particle, and particles coated with a film formed by coating resin particles such as styrene resin, urethane resin, melamine resin, epoxy resin, acrylic resin, phenol resin, and styrenebutadiene resin with a conductive thin film of gold, nickel, silver, copper and solder, etc. In general, such conductive particles are fine spherical particles of about 1 to 20 µm. Such a film is formed by a method in which a solvent is mixed to a one-component epoxy resin composition and the mixture is applied to a substrate formed of polyester, polyethylene, polyimide, polytetrafluoroethylene or the like, and then the solvent is dried off.
When a one-component epoxy resin composition according to the present invention is used as an insulating material or a sealing material, a filler such as silica is added to the one-component composition. When the one-component epoxy composition is used as a film, the film is formed by a method in which a solvent is added to the composition and the mixture is applied to a substrate formed of polyester or the like and then, the solvent is dried off.

### Examples

The present invention will be explained in more detail based on Examples, which will not be construed as limiting the technical scope and embodiments of the present invention. The term "parts" or "%" used in Examples and Comparative Examples, unless otherwise specified, are based on mass weight.
Resins and cured products thereof according to Examples and Comparative Examples were evaluated for physical properties by the methods described below.
(1) Epoxy equivalent
   The epoxy equivalent is the mass (g) of an epoxy resin containing an equivalent epoxy group and obtained in accordance with JIS K-7236.
(2) Gelation time
   Gelation time was obtained by the stroke cure method performed on a hot plate by use of a Curast meter V manufactured by TS Engineering Inc.
(3) FT-IR measurement
   Absorbance was measured by use of FT/IR-660 Plus manufactured by JASCO Corporation.
(4) Dispersibility of latent curing material in master batch type curing agent
   Toluene was added to a master batch type curing agent so as to contain 90% of a non-volatile component and allowed to stand still at 25°C for one hour. The resultant mixture was applied to a glass substrate in a film thickness of 20 µ. The number of agglomerations repelling the coating film was counted. The dispersibility was evaluated based on the number of agglomerations repelling the coating film.
   The case where the number of agglomerations repelling the coating film is 10 or less is indicated by a double circle, the case of 11 to 30 by an open circle, the case of 31 to 50 by a open triangle, and the case of more than 50 by a cross.
(5) Storage stability of a one-component epoxy resin composition
   A solvent mixture containing ethyl acetate and toluene in the ratio of 1:1 was added to a one-component epoxy resin composition so as to contain 70% of non-volatile components and allowed to stand still at 25°C for one hour. This mixture was applied on an aluminium board so as to obtain a film having a thickness of 30 µ (in terms of a thickness of dry film), dried by heating at 70°C for 5 minutes to remove the solvent from the composition, and stored at 50°C for 3 days. FT-IR measurement was performed before and after the storage at 50°C for 3 days to computationally obtain the rate of the remaining epoxy group.
   The remaining rate of 80% or more was indicated by a double circle, not less than 60% to less than 80% by an open circle, not less than 40% to less than 60% by an open triangle, and less than 40% by a cross.
(6) Curability of a one-component epoxy resin composition
   Gelation time of a one-component epoxy resin composition was measured. The case where the temperature at which the gelation time is less than 30 minutes is 100°C or less was expressed by an open circle, the case where the temperature is more than 100°C to not more than 110°C by an open triangle, and the case where the temperature exceeds 110°C by a cross.
(7) GPC measurement
   GPC was measured in the following measurement conditions. A calibration curve was formed by using polystyrene having a molecular weight of 580, 1,060, 1,940, 5,000, 10,050, 21,000 and 50,400 as a reference substance and then quantitative determination was performed.
   Column: HCL-8120GEL SUPER 1,000, 2,000, 3,000 serial manufactured by Tosoh Corporation
   Eluate: Tetrahydrofuran
   Flow amount: 0.6 ml/min
   Detector: measured at 254 nm by use of UV8020 manufactured by Tosoh
(8) Tg
   Tg was measured by DSC (DSC 220C manufactured by Seiko Instruments Inc.) at a temperature-raising rate of 10°C/minute.
(9) Storage stability of a master batch
   A one-component epoxy resin composition was stored at 40°C for 7 days and the viscosity before and after the storage were measured by a B-type viscometer and then viscosity-raising rate was obtained.
   The case where the viscosity raising rate is not less than 1.3 times is indicated by a double circle, the case where the rate is not less than 1.3 times to less than 2 times by an open circle, the case where the rate is not less than 2 times to less than 5 times by an open triangle, and the case where the rate is not less than 5 times by a cross.

### [Production Example 1]

### (Production of curing agent (A) for epoxy resin)

Two equivalents of a bisphenol A-type epoxy resin (epoxy equivalent: 185 g/equivalent, total chlorine amount: 1200 ppm; hereinafter referred to as an "epoxy resin c-1"), 0.66 mol of o-dimethylaminomethyl phenol, and 0.33 mole of dimethylamine were reacted in a solvent mixture containing methanol and toluene in the ratio of 1:1 (resin content: 50%) at 80°C for 8 hours, and then the solvent was removed at 180°C under reduced pressure to obtain a solid-state compound. The solid-state compound was pulverized to obtain particles of a curing agent a-1 for an epoxy resin having an average diameter of 2.5 µm.

### [Production Example 2]

### (Manufacturing of curing agent (A) for epoxy resin)

Two equivalents of a bisphenol A-type epoxy resin (epoxy equivalent: 185 g/equivalent, total chlorine amount: 20 ppm; hereinafter referred to as an "epoxy resin c-2") and 1.5 mol of 2-methyl imidazole were reacted in a solvent mixture containing methanol and toluene in the ratio of 1:1 (resin content: 50%) at 80°C for 6 hours, and then the solvent was removed at 180°C under reduced pressure to obtain a solid-state compound. The solid-state compound was pulverized to obtain particles of a curing agent a-2 for an epoxy resin having an average diameter of 3 µm.

### [Example 1]

To 100 parts by mass of xylene, 2 parts of Jeffamine D-230 (polyoxyalkylenediamine manufactured by Sun Techno Chemical Co., Ltd.) was dissolved. To the mixture, 75 parts by mass of the curing agent a-1 for an epoxy resin was added and dispersed. The temperature of the resultant solution was adjusted to 20°C. To this mixture, a solution mixture of 4 parts by mass of 1,8-diisocyanate-4-isocyanate methyl octane (hereinafter referred to as "OTI") and 100 parts by mass of xylene was added dropwise over 2 hours. After completion of dropwise addition, a reaction was performed at 40°C for 4 hours, continuously. After it was confirmed that OTI disappeared from the xylene phase, the reaction was terminated. In this manner, a latent curing agent for an epoxy resin was obtained. Furthermore, xylene was removed and 300 parts by mass of bisphenol A-type epoxy resin (epoxy equivalent: 189 g/equivalent, total chlorine amount: 1200 ppm; hereinafter referred to as an "epoxy resin c-3") was added and then, a shell-formation reaction was performed at 50°C for 8 hours to obtain a master batch type curing agent H-1 in which a core-shell type curing agent of an epoxy resin is dispersed in the epoxy resin c-3). The core-shell type curing agent was separated from the resultant master batch type curing agent H-1 by use of xylene and subjected to FT-IR measurement. As a result, it was confirmed that the core-shell type curing agent has bonding groups (x), (y), and (z).
The core-shell type curing agent obtained though the separation was further treated with methanol and tetrahydrofuran to separate a coating resin and subjected to Tg measurement. The Tg was 75°C.
Then, the dispersibility of the master batch type curing agent H-1 was evaluated. The evaluation results are shown in Table 1.
To 30 parts of the master batch type curing agent H-1, 100 parts of the epoxy resin c-3 was added and sufficiently mixed to obtain a one-component epoxy resin composition.
The storage stability and curability of the obtained one-component epoxy resin composition and storage stability of the master batch were evaluated. The evaluation results are shown in Table 1.

### [Example 2]

To 200 parts of an epoxy resin c-4, 100 parts by mass of the curing agent a-1 for an epoxy resin, 2 parts by mass of water, 1 part by mass of tolylene diisocyanate, and 7 parts by mass of OTI were added and reacted continuously for 3 hours at 40°C while stirring. As a result, 99% or more of isocyanate group was reacted. Thereafter, the shell formation reaction was performed at 40°C for 20 hours to obtain a master batch type curing agent H-2.
The core-shell type curing agent was separated from the master batch type curing agent H-2 by use of xylene and subjected to FT-IR measurement. As a result, it was confirmed that the core-shell type curing agent has bonding groups (x), (y) and (z). Furthermore, the dispersibility of the master batch type curing agent H-2 was evaluated. The evaluation results are shown in Table 1.
The obtained core-shell type curing agent obtained through separation was further treated in the same manner as in Example 1. The resultant coating resin had a Tg of 70°C.
To 30 parts of the master batch type curing agent H-2 thus obtained, 100 parts of the epoxy resin c-3 was added and sufficiently mixed to obtain a one-component epoxy resin composition.
The storage stability and curability of the obtained one-component epoxy resin composition and storage stability of the master batch were evaluated. The evaluation results are shown in Table 1.

### [Examples 3 and 4]

Master batch type curing agents H-3 and H-4 were obtained in accordance with the formulations shown in Table 1 in the same manner as in Example 2. It was confirmed that each of the curing agents had bonding groups (x), (y) and (z) in the same manner as in Example 2 and the dispersibility of the curing agents was evaluated.
The Tg values of the coating resins obtained in the same treatment as in Example 1 were 55°C and 58°C, respectively.
Furthermore, one-component epoxy resin compositions were obtained in the same manner as in Example 2. The storage stability, curability of these resin compositions and storage stability of a master batch were evaluated. The evaluation results are shown in Table 1.

### [Comparative Examples 1 and 2]

Master batch type curing agents H-5 and H-6 were obtained in accordance with the formulations shown in Table 1 in the same manner as in Example 2 and the dispersibility of the curing agents was evaluated.
The Tg values of the coating resins obtained in the same treatment as in Example 1 were 92°C and 98°C, respectively.
Furthermore, one-component epoxy resin compositions were obtained in the same manner as in Example 2 and storage stability, curability of the resin compositions and storage stability of a master batches were evaluated. The evaluation results are shown in Table 1.

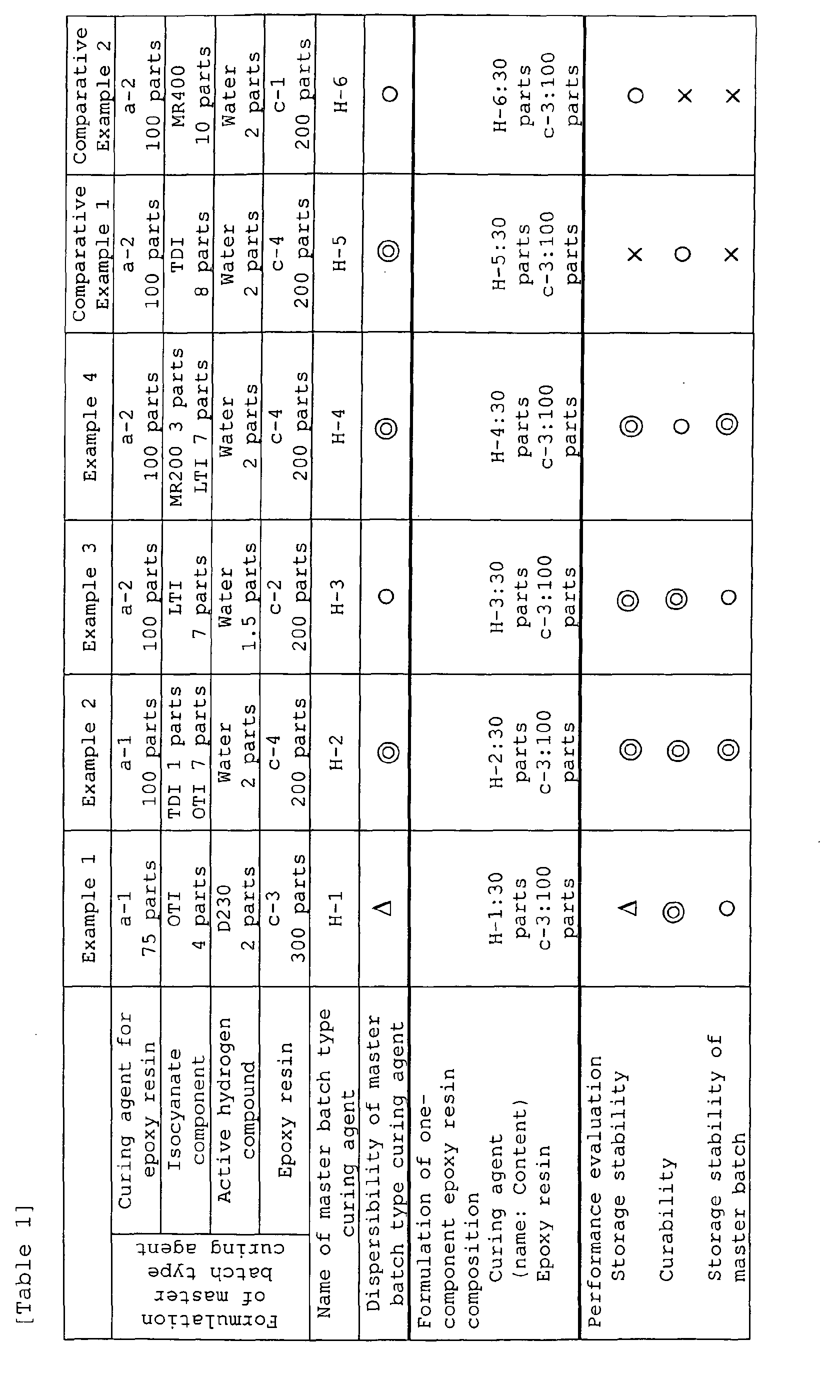

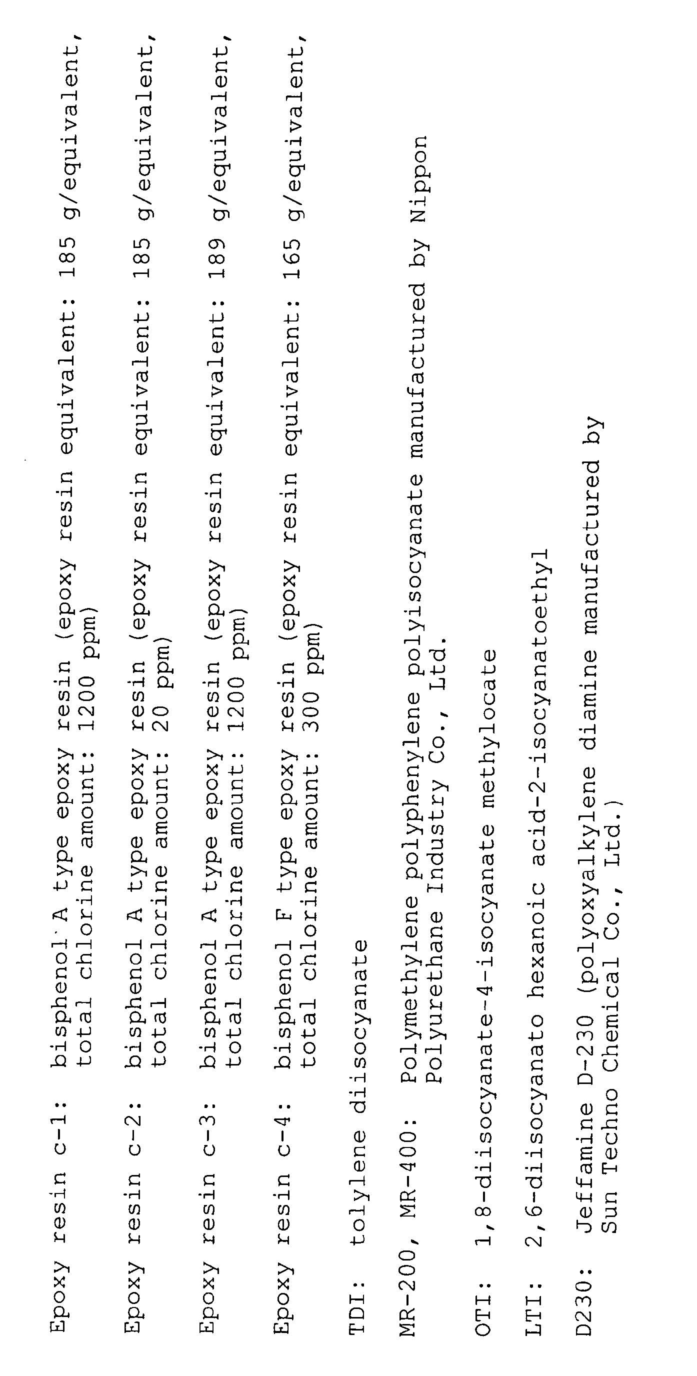

### [Example 5]

To 8 parts by mass of dicyandiamide previously pulverized into particles of 3 µm in average diameter, 3 parts by mass of the master batch type curing agent H-2 obtained in Example 2, 95 parts by mass of the epoxy resin H-2, 5 parts by mass of EP-4023 (CTBN modified epoxy resin manufactured by Adeka) and 20 parts by mass of calcium carbonate were added and homogenously mixed to obtain a one-component epoxy resin composition. The resultant composition had the storage stability represented by an open circle and cured at 140°C.

### [Example 6]

To 100 parts by mass of bisphenol F type epoxy resin (epoxy resin equivalent: 165 g/equivalent, total chlorine amount: 300 ppm), 80 parts by mass of methylhexahydro phthalic acid anhydride, and spherical molten silica powder (10 µm in average diameter) were added and homogeneously mixed. To the resultant mixture, 6 parts by mass of the master batch type curing argent H-2 obtained in Example 2 was added and homogeneously mixed to obtain a liquid sealing agent.
The liquid sealing agent thus obtained was applied to the space between a substrate and LSI and heated at 100°C for 3 hours and thereafter, at 150°C for 3 hours. As a result, the liquid sealing agent was cured and effectively worked as a sealant. The liquid sealing agent according to the composition was useful also as an insulating adhesive paste.

### [Example 7]

First, 40 parts by mass of bisphenol A type epoxy resin (epoxy resin equivalent: 2500 g/equivalent) was dissolved in 30 parts by mass of ethyl acetate. To this mixture, 40 parts by mass of the master batch type curing agent H-4 obtained in Example 4 and 20 parts by mass of conductive particles (cross-linked polystyrene plated with gold) of 8 µm in diameter were added and homogenously mixed to obtain a one-component epoxy resin composition. The resultant composition was applied onto a polyester film and ethyl acetate was dried off at 70°C to obtain an anisotropic conductive film.
The obtained anisotropic conductive film was sandwiched between electrodes and subjected to hot press performed on a hot plate of 200°C under application of a pressure of 30 kg/cm² for 20 seconds. As a result, the electrodes were electrically conducted in conjunction with each other and effectively works as an anisotropic conductive material.

### INDUSTRIAL APPLICABILITY

The one-component epoxy resin composition using a curing agent of the present invention is suitably used in the fields such as an adhesive agent, sealing material, filler, insulating material, conductive material, anisotropic conductive material, prepreg, film-type adhesive agent, and anisotropic conductive film, anisotropic conductive paste, insulative adhesive film, insulative adhesive paste, under-filler, potting material, die bonding material, conductive paste, and solder resist, etc.

## Claims

1. A latent curing agent for an epoxy resin comprising a curing agent (A) for an epoxy resin and a resin coating the curing agent (A) for an epoxy resin,
**characterized in that**
the resin coating the curing agent (A) for an epoxy resin comprises a structure in which two structures (structures (1)) are mutually bonded via one urea bond, the structures (1) each obtained by bonding three nitrogen atoms at a branching point via a linear or cyclic aliphatic hydrocarbon group which may optionally contain an ester structure; and at least one of the nitrogen atoms of each of the structures (1) is incorporated in the urea bond.

2. The latent curing agent for an epoxy resin according to claim 1, **characterized in that**
the resin coating the curing agent (A) for an epoxy resin further comprises an aromatic hydrocarbon group (2) bonded to not less than two nitrogen atoms; and
the ratio of the aromatic hydrocarbon group (2) bonded to not less than two nitrogen atoms to the total amount of the structures (1) and the aromatic hydrocarbon group (2) bonded to not less than two nitrogen atoms is between 0.5% by mass and 95% by mass.

3. The latent curing agent for an epoxy resin according to claim 2, **characterized in that**
the ratio of the aromatic hydrocarbon group (2) bonded to not less than two nitrogen atoms to the total amount of the structures (1) and the aromatic hydrocarbon group (2) bonded to not less than two nitrogen atoms is between 1% by mass and 80% by mass.

4. A latent curing agent for an epoxy resin comprising
a curing agent (A) for an epoxy resin; and
a resin coating the latent curing agent (A) for an epoxy resin and obtained by the reaction between an isocyanate component (b1), which has not less than three isocyanate groups and contains low molecular weight polyisocyanate having no molecular weight distribution in an amount of not less than 20% by mass, and an active hydrogen compound (b2).

5. The latent curing agent for an epoxy resin according to claim 4, **characterized in that** the resin coating the latent curing agent (A) for an epoxy resin has a bonding group (x) absorbing infrared ray having a wavelength of 1630 cm⁻¹ to 1680 cm⁻¹.

6. The latent curing agent for an epoxy resin according to claim 4 or 5, **characterized in that** the isocyanate component (b1) contains 20% by mass to 99% by mass of the low molecular weight polyisocyanate compound and 1% by mass to 80% by mass of other isocyanate compounds.

7. The latent curing agent for an epoxy resin according to any one of claims 1 to 6, **characterized in that** the curing agent (A) for an epoxy resin is an amine curing agent.

8. The latent curing agent for an epoxy resin according to any one of claims 1 to 7, **characterized in that** the resin coating the curing agent (A) for an epoxy resin has a glass transition temperature (Tg) of 80°C or less.

9. A core-shell type curing agent for an epoxy resin comprising the latent curing agent for an epoxy resin according to any one of claims 1 to 8 as a core and a reaction product between the curing agent (A) for an epoxy resin and an epoxy resin (C) as a shell.

10. A master batch type curing agent for an epoxy resin comprising 100 parts by mass of the latent curing agent for an epoxy resin according to any one of claims 1 to 8 or the core-shell type curing agent according to claim 6 and 10 to 50,000 parts by mass of the epoxy resin (C).

11. A one-component epoxy resin composition comprising, as main components,
100 parts by mass of an epoxy resin (D); and
0.1 to 1,000 parts by mass of the latent curing agent for an epoxy resin according to any one of claims 1 to 8, the core-shell type curing agent for an epoxy resin according to claim 9, or the master batch type curing agent for an epoxy resin according to claim 10.

12. A one-component epoxy resin composition comprising, as main components,
100 parts by mass of an epoxy resin (D);
1 to 200 parts by mass of at least one curing agent (E) selected from the group consisting of acid anhydrides, phenols, hydrazides, and guanidines; and
0.1 to 200 parts by mass of the latent curing agent for an epoxy resin according to any one of claims 1 to 8, the core-shell type curing agent for an epoxy resin according to claim 9, or the master batch type curing agent for an epoxy resin according to claim 10.

13. An anisotropic conductive material comprising the one-component epoxy resin composition according to claim 11 or 12.

14. A conductive adhesive material comprising the one-component epoxy resin composition according to claim 11 or 12.

15. An insulating adhesive material comprising the one-component epoxy resin composition according to claim 11 or 12.

16. A sealing material comprising the one-component epoxy resin composition according to claim 11 or 12.

17. A method of manufacturing a latent curing agent for an epoxy resin comprising coating a curing agent (A) for an epoxy resin with a film that is formed by reacting an isocyanate component (b1), which has not less than three isocyanate groups and contains low molecular weight polyisocyanate compound having no molecular weight distribution in an amount of 20% by mass or more, with an active hydrogen compound (b2).
